# EUROPEAN PATENT APPLICATION

(11) **EP 1 612 933 A1**
(43) Date of publication of application: **04.01.2006**
(21) Application number: 04722711.1
(22) Date of filing: 23.03.2004
(51) Int. Cl.: H03F 1/32

(54) **DISTORTION COMPENSATION DEVICE**

(30) Priority: 07.04.2003 JP 2003102798
(71) Applicant: Hitachi Kokusai Electric Inc., Tokyo 164-8511 (JP)
(72) Inventor: HONGO, Naoki,., Higachi-Nakano,Nakano-ku, Tokyo 164-8511 (JP)
(74) Representative: Senior, Alan Murray
(86) International application number: PCT/JP2004/003966
(87) International publication number: WO 2004/091094

(57) **Abstract**

Distortion compensation efficiency is improved by a distortion compensation apparatus that compensates for distortion generated in a signal amplified by an amplifier 12. A first distortion generation means that generates distortion with respect to a signal that is subject to amplification by amplifier 12 to reduce distortion generated by the amplifier is, for example, constituted by an analog fixed predistorter 11. A second distortion generation means that, based on the signal that is subject to amplification by the amplifier 12, generates distortion with respect to said signal to decrease components other than components decreased by distortion generated by the first distortion generation means, in respect of distortion generated by the amplifier, is constituted using a voltage-variable attenuator 9, voltage-variable phase shifter 10 and digital D/A converters 4, 6 and the like, realizing a lowering of the digital system clock frequency.

## Description

### TECHNTCAL FIELD

This invention relates to a distortion compensation apparatus that compensates for distortion generated by an amplifier that amplifies signals, and particularly to a distortion compensation apparatus equipped with first distortion generation means and second distortion generation means to provide efficient distortion compensation.

### BACKGROUND ART

In a base station apparatus (CDMA base station apparatus) provided in a mobile communications system that adopts W-CDMA (Wideband Code Division Multiple Access) as the mobile communications system, for example, wireless signals are required to reach mobile station apparatuses (CDMA mobile station apparatuses) that are physically far away, so an amplifier (amp) has to be used to greatly amplify the transmission output of a signal subject to transmission.

However, amplifiers are analog devices, so their input/output characteristics are nonlinear functions. In particular, from the amplification limit called the saturation point, the power of the signal output by the amplifier remains substantially constant even if the power input to the amplifier is increased. This nonlinear output produces nonlinear distortion.

Although, for example, signal components outside the desired signal band are suppressed to a low level by a band limiting filter prior to amplification of a transmission signal, nonlinear distortion is generated in a signal that has passed through the amplifier, causing leakage of signal components to outside the desired signal band (adjacent channels). In particular, the magnitude of such power leakage to adjacent channels is strictly regulated, so how to reduce this Adjacent Channel leak Power (ACP) has become a major topic.

To reduce this adjacent channel leak power, base station apparatuses can be equipped with a transmission power amplification unit having a function that carries out distortion compensation using Adaptive PreDistortion (APD) technology (transmission power amplification unit with adaptive predistortion). With respect to adaptive predistortion, various studies are being conducted for a distortion compensation system for realizing a high-efficiency amplifier (see, for example, Patent Document 1).

### Patent Document 1

### Unexamined Patent Publication No. 2002-76785

However, when the conventional transmission power amplification unit with adaptive predistortion, as described in the above example, is used to handle a signal to which predistortion has been applied by a predistortion system, the signal including the distortion becomes a wideband signal, which is inconvenient in that the signal clock frequency (clock frequency) of the digital system of a D/A converter or A/D converter or the like has to be very high.

The present invention was accomplished in light of these conventional circumstances, and has as its object to provide a distortion compensation apparatus that enables improved efficiency with respect to compensating for distortion generated by an amplifier that amplifies signals.

Specifically, the object of this invention is to provide a distortion compensation apparatus that when compensating for the distortion generated by, for example, an amplifier that amplifies signals, enables a digital device clock frequency to be lowered compared to the prior art.

### DISCLOSURE OF THE INVENTION

To attain the above object, the distortion compensation apparatus of this invention compensates for distortion generated by an amplifier that amplifies signals, as follows.

A first distortion generation means generates distortion with respect to a signal that is subject to amplification by an amplifier, to reduce distortion generated by the amplifier.

Based on a signal that is subject to amplification by an amplifier, a second distortion generation means generates distortion with respect to said signal to decrease components other than components decreased by distortion generated by the first distortion generation means in respect of distortion generated by the amplifier.

There is no particular limitation on the order of the processing for the generation of distortion by the first distortion generation means in respect of a signal to be amplified by the amplifier, and the processing for the generation of distortion by the second distortion generation means in respect of said signal; any configuration may be used that is effective in practice. For example, the second distortion generation means may be provided before the first distortion generation means, or the second distortion generation means may be provided after the first distortion generation means.

Also, while the invention describes a configuration equipped with a first distortion generation means and a second distortion generation means, a configuration may be used that is equipped with a further distortion generation means or a plurality thereof.

Therefore, in the distortion compensation apparatus of this invention, the sum of the distortion in respect of a signal subject to amplification by an amplifier that is generated by the first distortion generation means and the second distortion generation means is used to reduce distortion generated by the amplifier, increasing the efficiency of the distortion compensation.

Specifically, in a case in which ideal distortion compensation is performed, for example, with a configuration that uses only one distortion generation means, as in the prior art, the distortion generation means has to generate distortion that cancels the distortion generated by the amplifier (distortion having an inverse characteristic). However, with a configuration that uses a plurality of distortion generation means, such as that of the present invention, various settings can be used with respect to the distortion generated by each distortion generation means, as long as the sum of the distortion generated by each of the distortion generation means is distortion for cancelling the distortion generated by the amplifier (distortion having an inverse characteristic).

Thus, various signals can be used as the signal subject to amplification by the amplifier.

Various configurations can be used for the amplifier. For example, a single amplifier can be used, or a combination of a plurality of amplifiers.

As the distortion an amplifier generates in a signal when the signal is amplified by the amplifier, there is, for example, amplitude distortion and phase distortion.

Various degrees of distortion compensation accuracy may be used, to the extent that they are effective in practice.

Various configurations can be used for the first distortion generation means; for example, one can be used that generates distortion at a fixed mode setting, or that generates distortion based on feedback control, and so forth. Also, for example, a mode can be used to generate distortion based on the signal subject to amplification by the amplifier.

A configuration that generates distortion at a fixed mode setting is, for example, non-adaptive, and one that generates distortion based on feedback control is, for example, adaptive.

Various configurations can be used for the second distortion generation means; for example, it can be one that generates distortion based on feedback control.

The following is an example of a configuration used for the distortion compensation apparatus of this invention.

An analog device is used to constitute a first distortion generation means. The first distortion generation means uses a fixed mode setting to generate distortion in respect of a signal subject to amplification by an amplifier.

The second distortion generation means has a configuration that includes a digital device that performs operations based on a clock signal. With this second distortion generation means, a distortion generation mode control means controls the distortion generation mode based on the signal subject to amplification by the amplifier, and a distortion generation execution means generates distortion with respect to the signal subject to amplification by the amplifier, in the distortion generation mode controlled by the distortion generation mode control means.

Therefore, to reduce high-order frequency components contained in the distortion generated by the second distortion generation means, for example, the distortion generated by the first distortion generation means can be set to reduce the sampling frequency required by the digital device included in the second distortion generation means, thereby making it possible to reduce the frequency of the clock signal required by the digital device included in the second distortion generation means.

In this case, the mode of the distortion generated by the first distortion generation means is set to reduce high-order frequency components contained in the distortion components generated by the amplifier other than the components reduced by the distortion generated by the first distortion generation means.

Also, the first distortion generation means can be set to generate distortion that compensates for distortion generated by the amplifier to the extent that is possible or effective in practice.

As the high-order frequency components, there can be used, for example, fifth-order or seventh-order or higher order frequency components.

The wideband characteristic decreases when the high-order frequency components become smaller, which can be regarded as a narrowing of the frequency bandwidth.

Here, the first distortion generation means is constituted using just an analog device, for example.

Various devices may be used for the analog device.

The second distortion generation means, for example, can be constituted using both a digital device and an analog device, or it can be constituted using just a digital device.

Various devices may be used for the digital device or analog device.

As the distortion generation mode, there may be used, for example, an amplitude distortion generation mode, or a phase distortion generation mode, or both an amplitude and phase distortion generation mode.

Various means may be used for the distortion generation execution means, for example, means that changes the signal amplitude, or means that changes the signal phase, or means that changes both signal amplitude and phase.

The following is an example of a configuration used for the distortion compensation apparatus of this invention.

The second distortion generation means has a signal level detection means that detects the level of a signal subject to amplification by the amplifier, a signal level distortion generation mode correspondence memory means that stores the correspondence between the signal level and the distortion generation mode, and a distortion generation control execution means that, based on the stored content of the signal level distortion generation mode correspondence memory means, generates distortion in respect of the signal subject to amplification by the amplifier, using a distortion generation mode corresponding to the signal level detected by the signal level detection means.

In the second distortion generation means, also, based on the signal amplified by the amplifier, a signal level distortion generation mode correspondence content change means modifies the content of the correspondence between the signal level and the distortion generation mode stored by the signal level distortion generation mode correspondence memory means.

With the second distortion generation means, therefore, when compensating for distortion generated by the amplifier based on the signal level and the distortion generation mode, it is possible to improve the accuracy of the distortion compensation through feedback control, by updating the content of the correspondence based on the signal amplified by the amplifier.

Various levels can be used as the signal level detected by the signal level detection means, such as, for example, amplitude level, power level, envelope level, and so forth.

Similarly, various contents can be used as the correspondence between the signal level and the distortion generation mode. Generally, the level or phase of an output signal corresponding to the level of an input signal can be changed at the amplifier.

The signal level distortion generation mode correspondence memory means can be constituted using, for example, a memory or the like for storing information.

The following is an example of a configuration used for the distortion compensation apparatus of this invention.

A signal subject to amplification by the amplifier is input to the distortion compensation apparatus as a radio frequency analog signal.

The second distortion generation means has a signal level detection means that detects the level of an analog signal subject to amplification by the amplifier, and a digital control signal output means that has a signal level distortion generation mode correspondence memory means that stores the correspondence between the signal level and the distortion generation mode and outputs a digital control signal to realize the distortion generation mode corresponding to the signal level detected by the signal level detection means. Then, a control signal D/A conversion means in the second distortion generation means converts the digital control signal output by the digital control signal output means to an analog control signal and, based on the analog control signal obtained by the control signal D/A conversion means, an amplitude/phase distortion generation means generates amplitude or phase, or amplitude and phase, distortion in respect of the analog signal subject to amplification by the amplifier.

The first distortion generation means generates distortion with respect to the analog signal in which distortion was generated by the amplitude/phase distortion generation means constituted by the second distortion generation means, and outputs the analog signal in which said distortion was generated to the amplifier.

The first distortion generation means and the amplifier can be directly connected or can be indirectly connected via other circuit elements.

Therefore, by using the first distortion generation means, for example, to have the distortion generated by the amplitude/phase distortion generation means constituted by the second distortion generation means comprised principally of relatively low order frequency components, it is possible to make the frequency bandwidth of the control signal that controls the amplitude/phase distortion generation means relatively narrow, thereby making it possible to lower the sampling frequency or clock frequency required for the control signal D/A conversion means.

Third-order frequency components, for example, can be used as the low-order frequency components.

Also, when the principal frequency components are low-order, reducing the high-order frequency components, the wideband characteristic decreases, which can be regarded as a narrowing of the frequency bandwidth.

Various frequencies can be used as the radio frequency here.

The amplitude/phase distortion generation means generates distortion based on the analog control signal, and, as one example, generates high-order distortion by means of the high-order frequency components contained in the analog control signal and low-order distortion by means of the low-order frequency components contained in the analog control signal.

The amplitude/phase distortion generation means can be used, for example, to generate amplitude distortion, to generate phase distortion, or to generate both amplitude and phase distortion.

Various means may be used as the amplitude/phase distortion generation means. For example, an attenuator can be used that can variably control the amount of signal attenuation (variable attenuator), or an amplifier that can variably control the amount of signal amplification (variable amplifier), or a phase shifter that can variably control the signal phase shift change amount (phase shift amount) (variable phase shifter), and so forth. Also, a combination of variable attenuator and variable phase shifter, for example, can be used.

The following is an example of another configuration used for the distortion compensation apparatus of this invention.

A digital signal comprised of I components and Q components is input to the distortion compensation apparatus as the signal subject to amplification by the amplifier.

The second distortion generation means has a signal level detection means that detects the level of a digital signal subject to amplification by the amplifier, and a digital control signal output means that has a signal level distortion generation mode correspondence memory means that stores the correspondence between the signal level and the distortion generation mode and outputs a digital control signal to realize the distortion generation mode corresponding to the signal level detected by the signal level detection means. Then, an amplitude/phase distortion generation means in the second distortion generation means generates amplitude or phase, or amplitude and phase, distortion in respect of the digital signal subject to amplification by the amplifier, based on the digital control signal output by the digital control signal output means.

In this distortion compensation apparatus, the digital signal in which distortion was generated by the amplitude/phase distortion generation means constituted by the second distortion generation means is converted to an analog signal by a signal D/A conversion means, and a signal frequency conversion means converts the frequency of the analog signal obtained using the signal D/A conversion means to a radio frequency.

The first distortion generation means also generates distortion with respect to the radio frequency analog signal obtained using the signal frequency conversion means, and the analog signal in which this distortion has been generated is output to the amplifier.

The first distortion generation means and the amplifier can be directly connected or can be indirectly connected via other circuit elements.

Therefore, by using the first distortion generation means, for example, to have the distortion generated by the second distortion generation means comprised principally of relatively low-order frequency components, it is possible to make the frequency bandwidth of the signal in respect of the signal D/A conversion means relatively narrow, thereby making it possible to lower the sampling frequency or clock frequency required for the signal D/A conversion means.

Third-order frequency components, for example, can be used as the low-order frequency components.

Also, when the principal frequency components are low-order, reducing the high-order frequency components, the wideband characteristic decreases, which can be regarded as a narrowing of the frequency bandwidth.

The digital signals comprised of I components and Q components can be baseband (BB) signals.

The amplitude/phase distortion generation means can be used, for example, to generate amplitude distortion, to generate phase distortion, or to generate both amplitude and phase distortion.

Various means may be used as the amplitude/phase distortion generation means. For example, a vector processor may be used to apply amplitude distortion or phase distortion to the digital signals comprised of I components and Q components.

A further example of a configuration according to the present invention is described below.

As an example of a configuration of the distortion compensation apparatus of this invention, an amplified signal portion acquisition means acquires a portion of the signal amplified by the amplifier, and a distortion component extraction means extracts distortion components contained in the signal acquired by the amplified signal portion acquisition means, and the signal level distortion generation mode correspondence content change means modifies the content of the correspondence between the signal level and the distortion generation mode stored by the signal level distortion generation mode correspondence memory means to reduce the distortion components extracted by the distortion component extraction means.

As an example of another configuration, a signal frequency reduction means reduces the frequency of a signal acquired by the amplified signal portion acquisition means, a distortion component extraction means extracts distortion components contained in the signal whose frequency has been reduced by the signal frequency reduction means, and a distortion component A/D conversion means converts from an analog signal to a digital signal, the distortion components extracted by the distortion component extraction means, and based on the digital signal of the distortion component obtained by the distortion component A/D conversion means, the signal level distortion generation mode correspondence content change means modifies the content of the correspondence between the signal level and the distortion generation mode stored by the signal level distortion generation mode correspondence memory means.

Here, various means can be used for the amplified signal portion acquisition means, such as a coupler, for example.

Various means can also be used for the distortion component extraction means, such as a filter that extracts signal frequency components corresponding to the distortion components generated by the amplifier.

With the signal level distortion generation mode correspondence content change means, as an example of a control mode for reducing the extracted distortion components, it is preferable to use a control mode that minimizes the extracted distortion components.

The signal frequency reduction means can, for example, use a mode that reduces the signal frequency from the radio frequency to an intermediate frequency (IF) or baseband frequency.

As an example of a configuration of the distortion compensation apparatus of this invention, the signal subject to amplification by the amplifier is an orthogonally modulated signal.

In addition, a portion of the amplified by the amplifier is acquired by the amplified signal portion acquisition means, the signal acquired by the amplified signal portion acquisition means is orthogonally demodulated by a signal demodulation means, and the signal level distortion generation mode correspondence content change means modifies the content of the correspondence between the signal level and the distortion generation mode stored by the signal level distortion generation mode correspondence memory means to reduce the difference between the signal subject to amplification by the amplifier and the signal obtained by the orthogonal demodulation by the signal demodulation means.

Furthermore, as a configuration example, the signal frequency reduction means reduces the frequency of the signal acquired by the amplified signal portion acquisition means, a signal filtering means filters the signal whose frequency has been reduced by the signal frequency reduction means, and the signal filtered by the signal filtering means is converted from an analog signal to a digital signal by a filtered signal A/D conversion means. Then, the signal demodulation means performs orthogonal demodulation based on the digital signal of the distortion components obtained using the filtered signal A/D conversion means.

Various techniques can be used with respect to the modulation performed on the signal subject to amplification by the amplifier, such as QPSK (Quadrature Phase Shift Keying) or QAM (Quadrature Amplitude Modulation) and the like.

As a general example, QPSK or QAM or other such modulation is used to convert data to be transmitted to I signals (I component signals) and Q signals (Q component signals), which signals are converted to intermediate frequency (IF) signals by orthogonal modulation and up-converted to radio frequency (RF) signals. Again as a general example, received radio frequency (RF) signals are down-converted to intermediate frequency (IF) signals, which are converted to I signals and Q signals by orthogonal demodulation, and converted to data by demodulation.

In the amplifier distortion compensation, for example, for adaptive control, using I signals and Q signals, the difference between a signal subject to amplification by the amplifier and the signal obtained by orthogonal demodulation by the signal demodulation means is detected.

Various means can be used for the amplified signal portion acquisition means, such as a coupler, for example.

As an example of the control mode used by the signal level distortion generation mode correspondence content change means to reduce the difference between a signal subject to amplification by the amplifier and the signal obtained by orthogonal demodulation by the signal demodulation means, a control mode can be used that minimizes said difference.

The signal frequency reduction means can, for example, use a mode that reduces the signal frequency from a radio frequency to an intermediate frequency.

Various means can be used for the signal filtering means, such as, for example, a filter that extracts signal frequency components corresponding to the components of the signal subject to amplification by the amplifier.

The distortion compensation apparatus of this invention can be provided, for example, with a wireless or wired communication apparatus, transmitter, transceiver and so forth, and a signal to be transmitted can be used as the signal subject to amplification by the amplifier.

As an example, the distortion compensation apparatus of this invention can be provided in a base station apparatus of a wireless communication system that employs a CDMA system or the like, and a multicarrier signal that is to be transmitted to a mobile station apparatus or the like used as the signal subject to amplification by the amplifier.

Also, the distortion compensation apparatus of this invention can be provided in an amplification apparatus equipped with an amplifier.

### BRIEF DESCRIPTION OF DRAWINGS

Figure 1 is a diagram showing an example of a configuration of an amplification apparatus according to a first embodiment of the present invention.
Figure 2 is a diagram showing an example of distortion compensation table characteristic.
Figure 3 is a diagram showing an example of the spectrum of a control signal output from a D/A converter.
Figure 4 is a diagram showing an example of the spectrum of a control signal output from a D/A converter.
Figure 5 is a diagram showing an example of a comparison of spectra of control signals output from a D/A converter.
Figure 6 is a diagram showing an example of the configuration of an amplification apparatus according to a second embodiment of the present invention.
Figure 7 is a diagram showing an example of a comparison of spectra of signals output from a D/A converter.
Figure 8 is a diagram showing an example of the configuration of an amplification apparatus according to a third embodiment of the present invention.
Figure 9 is a diagram showing an example of an ideal distortion compensation table characteristic.
Figure 10 is a diagram showing an example of distortion compensation table characteristics in a case in which fixed predistortion and adaptive predistortion are used.
Figure 11 is a diagram showing an example of the spectrum of a control signal output from a D/A converter, using only adaptive PD in the case of (a), and fixed PD + adaptive PD in the case of (b).
Figure 12 is a diagram showing an example of the spectra of signals output from a D/A converter, using only adaptive PD in the case of (a), and fixed PD + adaptive PD in the case of (b).
Figure 13 is a diagram showing an example of the configuration of a transmission power amplification unit equipped with an adaptive predistorter.
Figure 14 is a diagram showing an example of the configuration of a transmission power amplification unit equipped with an adaptive predistorter.
Figure 15 is a diagram showing an example of the output characteristics of a D/A converter.
Figure 16 is a diagram showing an example of the spectra of control signals output from a D/A converter, with sampling frequency fs1 (fs1<fs2) in the case of (a), and sampling frequency fs2 (fs1<fs2) in the case of (b).
Figure 17 is a diagram showing an example of the spectra of signals output from a D/A converter, with sampling frequency fs1 (fs1<fs2) in the case of (a), and sampling frequency fs2 (fs1<fs2) in the case of (b).

### BEST MODE FOR CARRYING OUT THE INVENTION

Embodiments of the present invention will now be described with reference to the drawings.

First, an embodiment of the configuration and operation of a transmission power amplification unit equipped with an adaptive predistorter that can apply the present invention will be described.

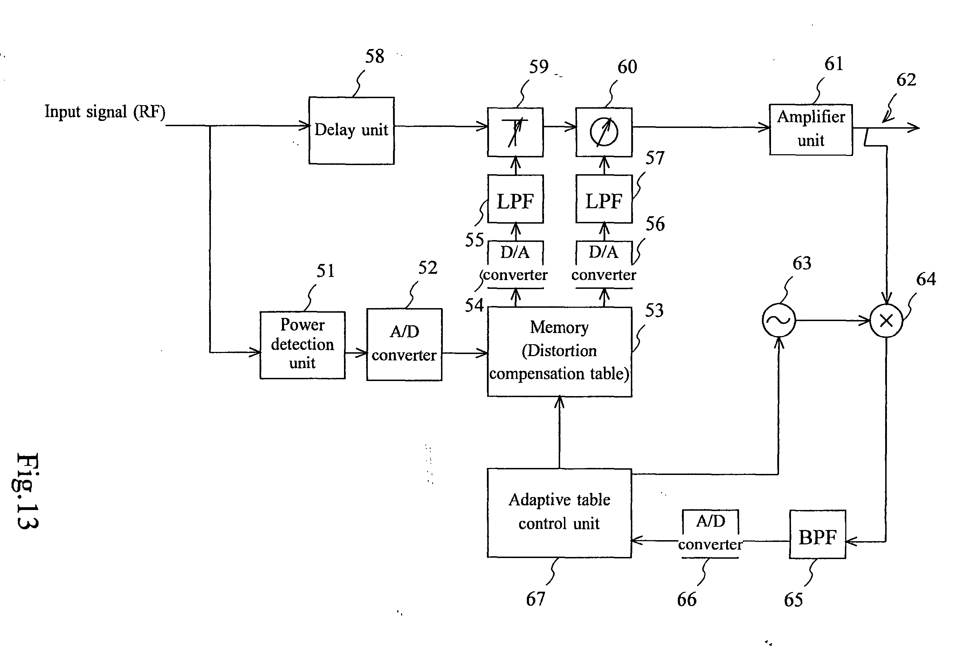

Figure 13 shows an embodiment of the configuration of a transmission power amplification unit equipped with an adaptive predistorter that performs analog predistortion.

An example of the operation of the illustrated transmission power amplification unit equipped with an adaptive predistorter will now be described.

A radio frequency (RF) analog signal is input to a power detection unit 51 and a delay unit 58.

At the power detection unit 51, for example, envelope detection is performed to detect the power of the input signal. A voltage representing the detection result is converted from an analog signal to a digital signal by an A/D (Analog to Digital) converter 52, and associated as a reference argument of a distortion compensation table constituted by a memory 53, for example.

A table for performing distortion compensation by the predistortion method is stored in the distortion compensation table of the memory 53. The table describes information on an inverse characteristic with a nonlinear characteristic in the amplitude-phase plane that is to be compensated. Ordinarily, it describes information relating to AM (Amplitude Modulation)-AM conversion and AM-PM (Phase Modulation) conversion using the input signal power as an index. Here, AM-AM conversion relates to amplitude, and AM-PM conversion relates to phase.

By referring to the distortion compensation table of memory 53, in association with input from the A/D converter 52 (input signal power, in this example), one digital control signal is output to a D/A (Digital to Analog) converter 54, and the other digital control signal is output to a D/A converter 56.

The digital control signal to the D/A converter 54 is thereby converted to an analog signal, limited to the required frequency component band by an LPF 55 and input to a voltage-variable attenuator 59 that compensates for the AM-AM conversion to control the voltage-variable attenuator 59.

The digital control signal to the D/A converter 56 is thereby converted to an analog signal, limited to the required frequency component band by an LPF 57 and is input to a voltage-variable attenuator 60 that compensates for the AM-PM conversion to control the voltage-variable attenuator 60.

The input signal, delayed by a delay time applied by the delay unit 58, is input to the voltage-variable attenuator 59. As an example, the delay time is set so that the time at which the input signal is input to the voltage-variable attenuator 59 coincides with the time at which the output (control signal) from the D/A converter 54 based on the input signal power arrives at the voltage-variable attenuator 59.

Thus, in the voltage-variable attenuator 59 and the voltage-variable phase shifter 60 which correspond to a predistorter, a signal that is predistorted by the predistortion method is amplified by an amplifier unit 61. When ideal distortion compensation is performed, the output signal from the amplifier unit 61 (amplified signal) is a signal with no distortion.

To carry out feedback control, a portion of the output signal from the amplifier unit 61 is taken off by a directional coupler 62. The signal portion is down-converted by a mixer 64, using an oscillation signal from an oscillator 63 controlled by an adaptive table control unit 67. After the down-conversion, the signal is stripped of distortion frequency band components by a bandpass filter (BPF) 65, and the resulting signal is converted from an analog signal to a digital signal by an A/D converter 66 and input to the adaptive table control unit 67.

In this way, information relating to the distortion power is input into the adaptive table control unit 67 from the A/D converter 66. Also, the adaptive table control unit 67 adaptively controls the distortion compensation table to reduce the distortion power by updating the content of the distortion compensation table stored in the memory 53. Doing this decreases distortion components remaining in the output signal from the amplifier unit 61.

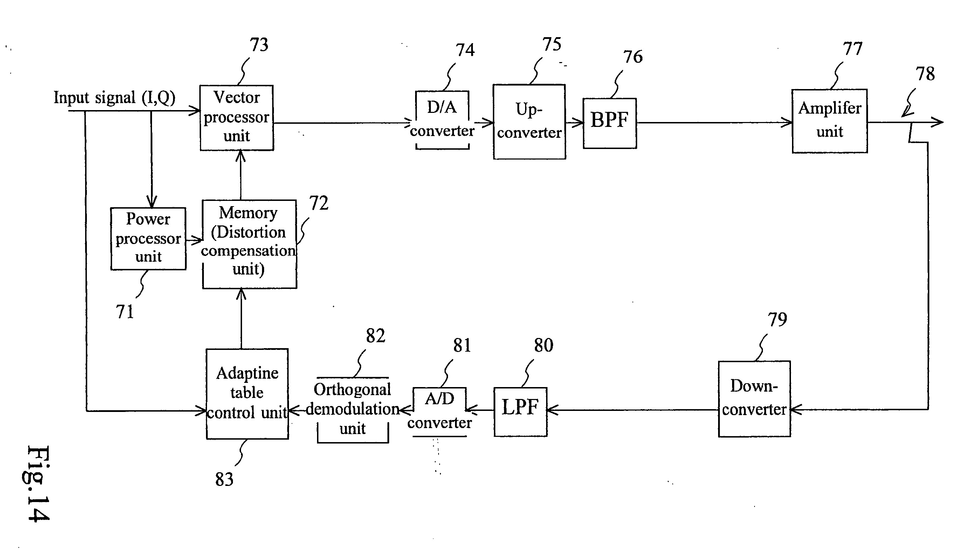

Figure 14 shows an example of the configuration of a transmission power amplification unit equipped with an adaptive predistorter that performs digital predistortion.

An example of the operation of the illustrated transmission power amplification unit equipped with an adaptive predistorter will now be described.

A digital signal comprised of I-phase component (I components) and Q-phase components (Q components) is input to a power processor unit 71, a vector processor unit 73 and an adaptive table control unit 83. The input signal is, for example, a multicarrier signal that is orthogonally modulated before being input to the transmission power amplification unit equipped with an adaptive predistorter.

The power of the input signal is detected by the power processor unit 71. The detection result is associated as a reference argument of a distortion compensation table constituted by a memory 72.

A table for performing distortion compensation by the predistortion method is stored in the distortion compensation table of the memory 72. The table describes information on an inverse characteristic with a nonlinear characteristic in the amplitude-phase plane that is to be compensated. Ordinarily, it describes information relating to AM-AM conversion and AM-PM conversion using the input signal power as an index.

Here, AM-AM conversion relates to amplitude, and AM-PM conversion relates to phase.

In order to perform vector processing relating to AM-AM conversion or AM-PM conversion, control information is stored in the distortion compensation table, using an orthogonal coordinate arrangement (for example, (x, y) or (I, Q) and the like).

When the distortion compensation table is referenced, a digital control signal corresponding to the input (in this example, input signal power) from the power processor unit 71 is output from the memory 72 to the vector processor unit 73.

The vector processor unit 73 corresponding to the predistorter controls the amplitude and phase of the input signal in accordance with the digital control signal that is the result of the referencing of the distortion compensation table.

In this way, an input signal predistorted by the vector processor unit 73 is converted from a digital signal to an analog signal by a D/A converter 74 and frequency converted to a radio frequency (RF) signal by an up-converter 75, and a bandpass filter (BPF) 76 then strips the frequency converted signal of unnecessary signals outside the required frequency band.

After this processing, in the vector processor unit 73, as described above, the signal predistorted by the predistortion method is amplified by an amplifier unit 77. When ideal distortion compensation is performed, the output signal from the amplifier unit 77 (amplified signal) is a signal with no distortion.

To carry out feedback control, a portion of the output signal from the amplifier unit 77 is taken off by a directional coupler 78. The signal portion is frequency converted to a low frequency by a down-converter 79, and after the frequency conversion, the signal is stripped of unnecessary signals outside the required frequency band. The signal from which unnecessary signals outside the band have been removed by the low pass filter 80 is converted from an analog signal to a digital signal by an A/D converter 81. Orthogonal demodulation is performed by an orthogonal demodulation unit 82 based on the digital signal, and the result of the orthogonal demodulation is input to an adaptive table control unit 83 as a feedback signal.

A feedback signal from the orthogonal demodulation unit 82 is input into the adaptive table control unit 83 together with the input of the input signal, and the adaptive table control unit 83 adaptively controls the distortion compensation table to reduce the error between the input signal and the feedback signal by updating the content of the distortion compensation table stored in the memory 72.Doing this decreases distortion components remaining in the output signal from the amplifier unit 77.

Next, difficulties pertaining to problems the present invention is attempting to resolve concerning the type of transmission power amplification unit equipped with an adaptive predistorter shown in Figure 13 and Figure 14 will be explained in detail.

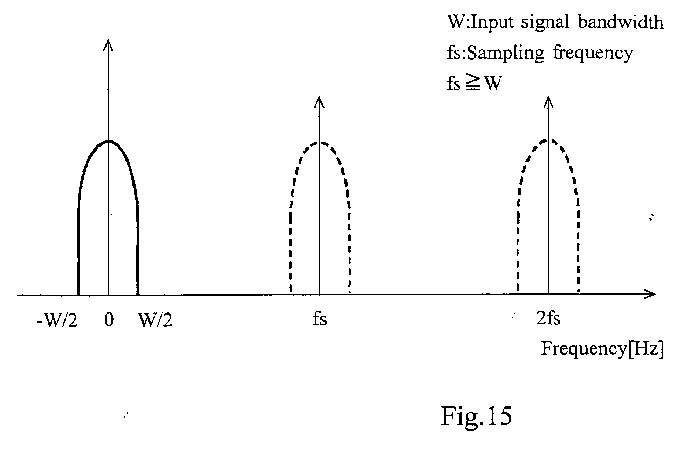

Figure 15 shows an example of the output characteristics of a D/A converter.

The drawing shows an example of the spectrum of a signal output from a D/A converter in a case in which the signal having a frequency bandwidth W [Hz] is input to the D/A converter and the sampling frequency is fs [Hz]. In the drawing, the horizontal axis of the graph represents frequency [Hz], and the vertical axis represents spectral intensity.

For convenience of explanation, as shown in the drawing, if the center frequency of an input signal (indicated by a solid line) is 0 [Hz], image signals (indicated by a dotted line) of frequency fs [Hz], 2fs [Hz], ..., nfs [Hz] appear. Here, n is an arbitrary integer of 1 or more.

The sampling theorem is satisfied by the condition "sampling frequency fs ≥ input signal frequency bandwidth W".

When this condition is considered, in the case of the transmission power amplification unit equipped with an adaptive predistorter shown in the above Figure 13 or Figure 14, the input signal after predistortion has a wider bandwidth than the frequency bandwidth of the input signal prior to predistortion, so the required sampling frequency becomes very high, and the required clock frequency becomes very high.

For example, in a case in which third-order distortion components are considered, the input signal after predistortion has a bandwidth that is three or more times that of the frequency bandwidth of the input signal prior to predistortion, so the required sampling frequency is also three or more times higher. Similarly, in a case in which fifth-order distortion components are considered, the input signal after predistortion has a bandwidth that is five or more times that of the frequency bandwidth of the input signal prior to predistortion, so the required sampling frequency is also five or more times higher.

Next, the transmission power amplification unit equipped with an adaptive predistorter shown in Figure 13 will be specifically explained.

An inconvenience with the illustrated transmission power amplification unit equipped with an adaptive predistorter has been the need for a very high clock frequency for the digital system, starting with the D/A converters 54, 56 and the A/D converter 52.

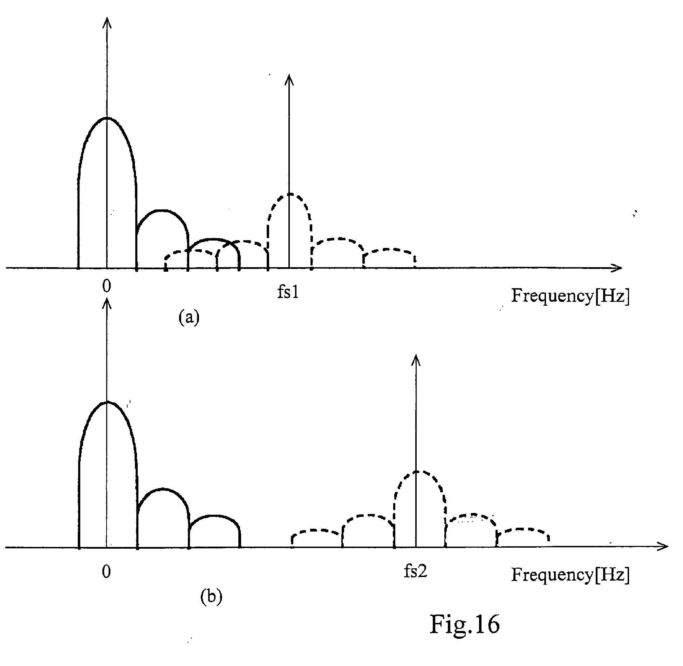

Figure 16 (a) shows an example of the spectrum of a control signal output from the D/A converters 54, 56 when using a relatively low sampling frequency fs1 [Hz].

And, Figure 16 (b) shows an example of the spectrum of a control signal output from the D/A converters 54, 56 when using a relatively high sampling frequency fs2 [Hz]. Here, fs1 < fs2.

In the graphs of (a) and (b) of the drawing, the horizontal axis represents frequency [Hz], and the vertical axis represents spectral intensity.

Also, (a) and (b) of the drawing show the spectrum of a control signal (indicated by a solid line) having a center frequency of 0 [Hz], and an image signal (indicated by a dotted line) having a center frequency of fs1 [Hz] and fs2 [Hz].

As shown in (a) of the drawing, when the sampling frequency fs1 is low compared to what is a sufficient value, the control signal output from the D/A converters 54, 56 is overlaps the image signal, which is undesirable. As such, it is necessary to use a very high sampling frequency fs2, as shown in (b).

When this is the case, along with the use of a very high sampling frequency in the D/A converters 54, 56, it is also necessary to use a very high clock frequency with respect to other digital components. Raising the clock frequency makes a device costly, and can be technically difficult or impossible to achieve.

Next, the transmission power amplification unit equipped with an adaptive predistorter shown in Figure 14 will be specifically explained.

An inconvenience with the illustrated transmission power amplification unit equipped with an adaptive predistorter has been the need for a very high clock frequency for the digital system, starting with the D/A converter 74 and the A/D converter 81.

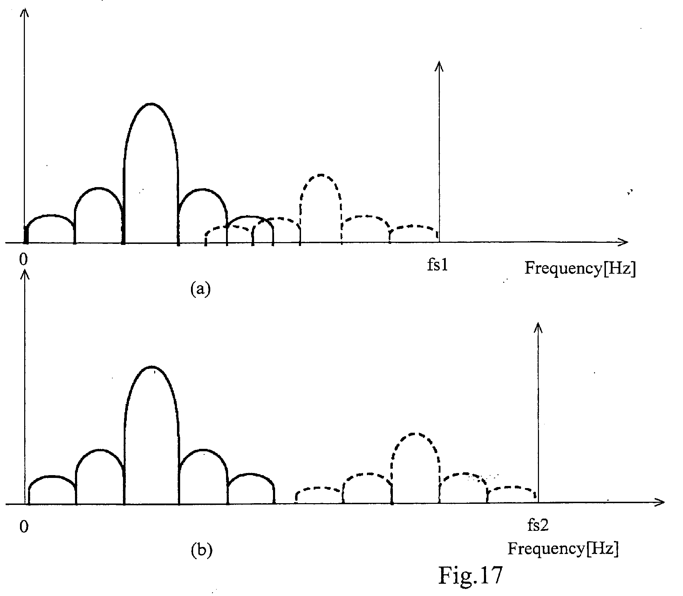

Figure 17 (a) shows an example of the spectrum of a predistorted input signal output from the D/A converter 74 when using a relatively low sampling frequency fs1 [Hz].

And, Figure 17 (b) shows an example of the spectrum of a predistorted input signal output from the D/A converter 74 when using a relatively high sampling frequency fs2 [Hz]. Here, fs1 < fs2.

In the graphs of (a) and (b) of the drawing, the horizontal axis represents frequency [Hz], and the vertical axis represents spectral intensity.

In the drawing, (a) and (b) also show the spectrum of the predistorted input signal (indicated by a solid line) having a frequency location that is high compared to 0 [Hz], and an image signal (indicated by a dotted line) having a frequency location that is low compared to fs1 [Hz] and fs2 [Hz].

As shown in (a) of the drawing, when the sampling frequency fs1 is low compared to what is a sufficient value, the predistorted signal output from the D/A converter 74 overlaps the image signal, which is undesirable. As such, it is necessary to use a very high sampling frequency fs2, as shown in (b).

When this is the case, along with the use of a very high sampling frequency in the D/A converter 74, it is also necessary to use a very high clock frequency with respect to other digital components. Raising the clock frequency makes a device costly, and is technically difficult or impossible to achieve.

Next, embodiments of the present invention will be described.

A first embodiment of this invention will now be described.

This embodiment is one in which the distortion compensation apparatus of the present invention is applied to an amplification apparatus equipped with a distortion compensation function (transmission power amplification unit equipped with an adaptive predistorter) such as that shown in Figure 13, to reduce the clock signal frequency (clock frequency) compared, for example, to the prior art, by using a fixed predistorter.

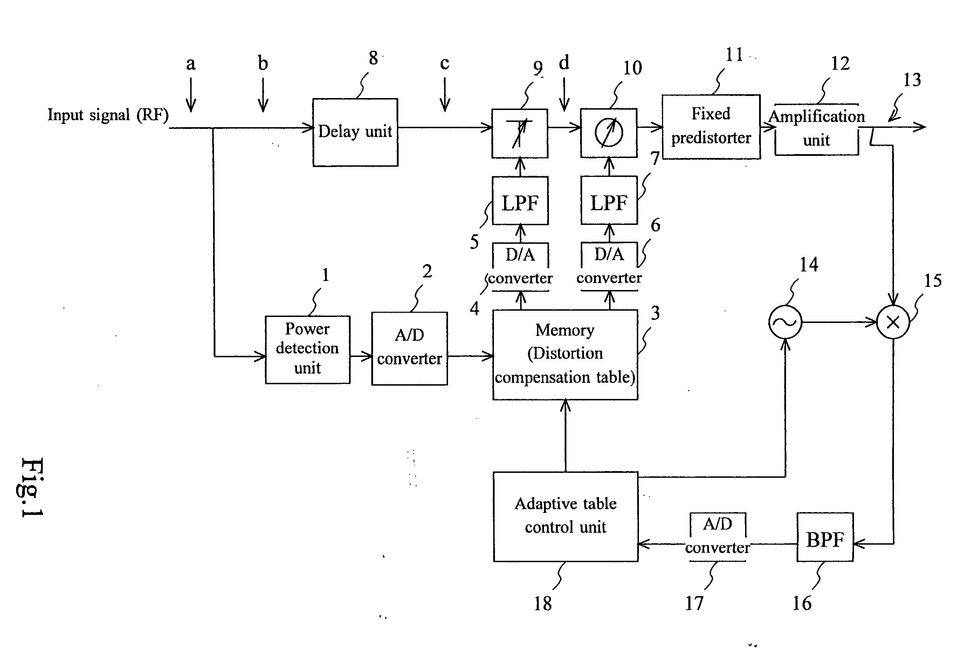

Figure 1 shows an example of the configuration of the amplification apparatus of this embodiment.

The amplification apparatus of this embodiment comprises a power detection unit 1, an A/D converter 2, a memory 3 that stores a distortion compensation table, a D/A converter 4, a low pass filter (LPF) 5, a D/A converter 6, a low pass filter (LPF) 7, a delay unit 8, a directional coupler 13, an oscillator 14, a mixer 15, a bandpass filter (BPF) 16, an A/D converter 17, and an adaptive table control unit 18.

The configuration and operation of the amplification apparatus of this embodiment are the same as the configuration and operation of the amplification apparatus shown in Figure 13, except for the portion pertaining to the lowering of the clock frequency required for the digital system by the use of the fixed predistorter 11, for example.

The operation of the amplification apparatus of this embodiment will now be described.

A signal to be input to the amplification apparatus of this embodiment from an upstream processor unit (not shown) is split into two signals, the first split signal is input to the power detection unit 1 and the second split signal is input to the delay unit 8.

The power detection unit 1 detects the power of a radio frequency (RF) signal to be transmitted, input from an upstream processor unit (not shown), and outputs the detection result to the A/D converter 2.

The A/D converter 2 converts the power detection result input from the power detection unit 1 from an analog signal to a digital signal and outputs it to the memory 3.

Based on the content of the stored distortion compensation table, the memory 3 uses the digital signal input from the A/D converter 2 as an index to reference the distortion compensation table, and outputs the result to the D/A converters 4, 6. Specifically, the distortion compensation table stores the association between a digital signal value representing a power detection result, and a control value to the voltage-variable attenuator 9 and a control value to the voltage-variable phase shifter 10. The memory 3 references the distortion compensation table and outputs to the D/A converter 4 the control value (digital control signal) to the voltage-variable attenuator 9 associated with the value of the digital signal input from the A/D converter 2, and outputs to the D/A converter 6 the control value (digital control signal) to the voltage-variable phase shifter 10 associated with the value of the digital signal input from the A/D converter 2.

The D/A converter 4 converts the digital control signal input from the memory 3 to an analog signal and outputs it to the LPF 5.

The LPF 5 filters the analog control signal input from the D/A converter 4, and outputs it to the control terminal of the voltage-variable attenuator 9.

The D/A converter 6 converts the digital control signal input from the memory 3 to an analog control signal and outputs it to the LPF 7.

The LPF 7 filters the analog control signal input from the D/A converter 6, and outputs it to the control terminal of the voltage-variable phase shifter 10.

The delay unit 8 delays the radio frequency (RF) signal which is to be transmitted that is input from an upstream processor input (not shown) to match the timing at which the control signals based on the input signal are input to the voltage-variable attenuator 9 and voltage-variable phase shifter 10, and outputs it to the voltage-variable attenuator 9. As one example, the delay unit 8 delays the input radio frequency (RF) signal by a time that is the same as the time required until a control signal based on the input signal is converted to an analog signal by the D/A converter 4.

The voltage-variable attenuator 9 controls the amplitude of the delayed input signal input from the delay unit 8, using an amount of attenuation that is in accordance with the analog control signal input from the LPF 5, and after said control, outputs the signal to the voltage-variable phase shifter 10.

Instead of the voltage-variable attenuator 9, it is possible to use a voltage-variable amplifier or the like that controls the signal amplitude using, for example, an amount of amplification that is in accordance with the analog control signal.

The voltage-variable phase shifter 10 controls the phase of the signal input from the voltage-variable attenuator 9, using a phase shift amount that is in accordance with the analog control signal input from the LPF 7, and after said control, outputs the signal to the fixed predistorter 11.

This embodiment shows a configuration in which the voltage-variable phase shifter 10 is provided upstream of the voltage-variable attenuator 9. However, the order in which they are arranged can be the reverse of the order used in this embodiment, with the voltage-variable attenuator 9 being provided upstream of the voltage-variable phase shifter 10.

The fixed predistorter 11 is constituted using a nonlinear device, for example, generates distortion with respect to a signal input from the voltage-variable phase shifter 10, and outputs the distortion-generated signal to the amplification unit 12. Also, the fixed predistorter 11 generates distortion of the signal that corresponds to the level of the input signal.

In this way, in this embodiment, distortion compensation is carried out by the predistortion method by both adaptive predistortion using the voltage-variable attenuator 9 and voltage-variable phase shifter 10, and fixed predistortion (nonlinear predistortion) using the fixed predistorter 11.

The amplification unit 12 amplifies the signal input from the fixed predistorter 11 and outputs the amplified signal to a downstream antenna (not shown), for example.

In this embodiment, also, distortion generated in the signal by the amplification unit 12 is reduced by amplitude distortion generated by the voltage-variable attenuator 9, phase distortion generated by the voltage-variable phase shifter 10, or amplitude distortion or phase distortion generated by the fixed predistorter 11.

The directional coupler 13 extracts part of the amplified signal output from the amplification unit 12, and outputs the extracted signal to the mixer 15.

The oscillator 14 oscillates the signal of a frequency controlled by the adaptive table control unit 18 and outputs it to the mixer 15.

The mixer 15 combines the amplified signal input from the directional coupler 13 and the signal input from the oscillator 14, converts the frequency of the amplified signal, and after the frequency conversion, outputs the amplified signal to the BPF 16.

The BPF 16 limits the band of the signal input from the mixer 15, and outputs the band-limited signal to the A/D converter 17.

The A/D converter 17 converts the signal input from the BPF 16 from an analog signal to a digital signal, and outputs it to the adaptive table control unit 18.

Based on the digital signal input from the A/D converter 17, the adaptive table control unit 18 updates the content of the distortion compensation table stored in the memory 3 and controls the frequency of the signal oscillated by the oscillator 14.

Here, in this embodiment, distortion components contained in the amplified signal are extracted by the BPF 16, and the adaptive table control unit 18 controls the updating of the content of the distortion compensation table to decrease the level of said distortion components. The bandpass characteristic of the BPF 16 and the frequency of the signal oscillated by the oscillator 14 are set or controlled to properly perform such control.

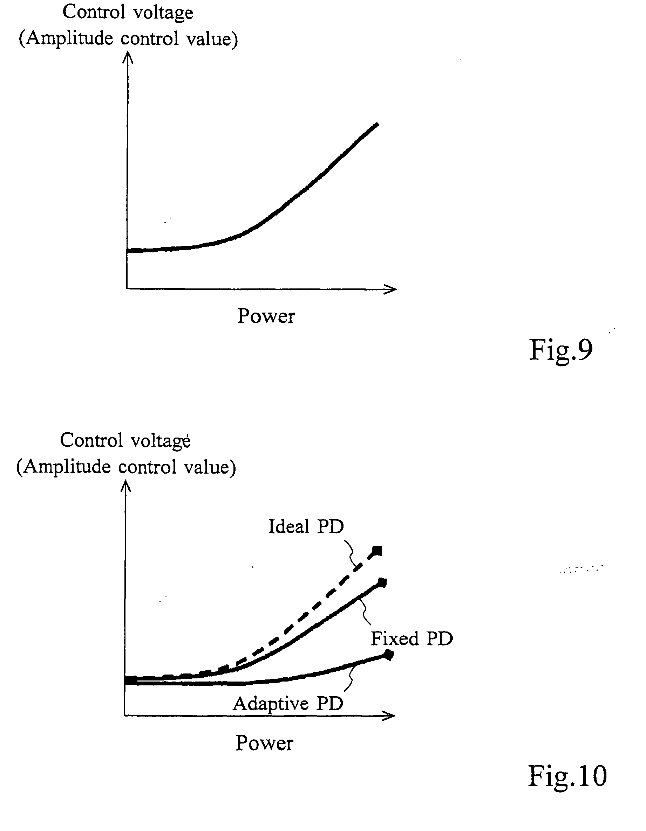

Next, the principle of the clock frequency reduction using the fixed predistorter 11 in the amplification apparatus of this embodiment will be described, with reference to Figures 9 to 11.

A distortion compensation table generally has a table relating to amplitude and a table relating to phase, but to simplify the explanation, here the explanation focuses just on a table relating to amplitude. A table relating to amplitude is the same as with respect to a table relating to phase.

Figure 9 shows an example of the characteristic of the ideal distortion compensation table of an adaptive predistorter using the voltage-variable attenuator 9 and the voltage-variable phase shifter 10 in a configuration that is not equipped with the fixed predistorter 11. In the graph of the drawing, the horizontal axis represents power and the vertical axis represents control signal voltage (control voltage).

Figure 10 shows an example of the characteristics of distortion compensation by the fixed predistorter 11 in a case in which the fixed predistorter 11 is provided, and an example of the characteristic of an ideal distortion compensation table of an adaptive predistorter using the voltage-variable attenuator 9 and the voltage-variable phase shifter 10. In the graph of the drawing, the horizontal axis represents power and the vertical axis represents control signal voltage (control voltage).

The characteristics shown in Figure 10 are a fixed predistortion (fixed PD) characteristic together with an adaptive predistortion (adaptive PD) characteristic; a match with the ideal predistortion (ideal PD) shown in Figure 9 is ideal and desirable.

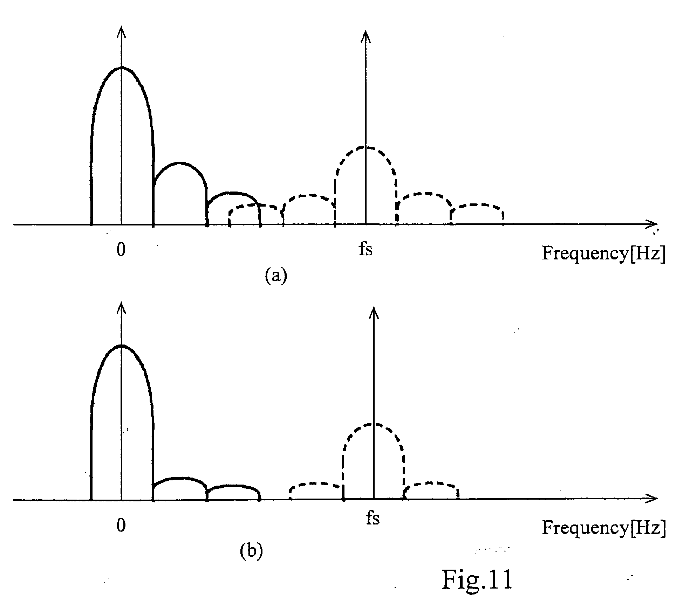

Figure 11 (a) shows, in a case in which the fixed predistorter 11 is not provided, an example of the spectrum of a control signal output from the D/A converter 4 (or the same, with respect to D/A converter 6), when the distortion compensation table of memory 3 has the ideal characteristic shown in Figure 9.

Figure 11 (b) shows, in a case in which the fixed predistorter 11 is provided, an example of the spectrum of a control signal output from the D/A converter 4 (or the same, with respect to D/A converter 6), when the distortion compensation table of memory 3 has the ideal adaptive predistortion (adaptive PD) characteristic shown in Figure 10.

In the graphs shown in Figure 11 (a) and (b), the horizontal axis represents frequency [Hz], and the vertical axis represents spectral intensity.

Also, (a) and (b) of the drawing show the spectrum of a control signal (indicated by a solid line) having a center frequency of 0 [Hz], and an image signal (indicated by a dotted line) having a center frequency of fs [Hz].

As shown in Figure 11 (a) and (b), even at the sampling frequency fs at which the control signal output from the D/A converter 4 and the image signal overlap when there is no fixed predistorter 11, providing the fixed predistorter 11 makes it possible to make the frequency bandwidth of the control signal output from the D/A converter 4 relatively small (narrow), making it possible to avoid overlap between the control signal and the image signal.

Thus, with a configuration that is equipped with the fixed predistorter 11, as in this embodiment, the sampling frequency fs can be made lower compared to a case in which a fixed predistorter is not provided, as shown in Figure 13, for example, which makes it possible to reduce the clock frequency of a digital system such as the D/A converters 4 and 6.

Since an analog device is used as the fixed predistorter 11, there is no particular connection with the sampling rate (sampling frequency). In this embodiment, by using this type of fixed predistorter 11, the spectral intensity of the distortion components generated by an adaptive predistorter is attenuated, thereby achieving a lowering of the sampling frequency fs and the clock frequency.

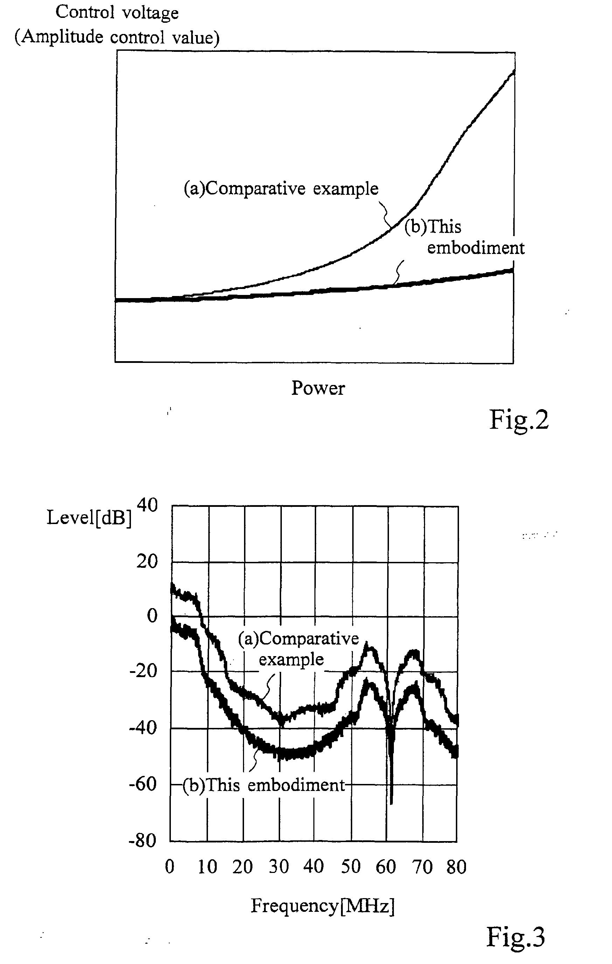

Next, as a concrete example of the effect obtained by the amplification apparatus of this embodiment, results obtained by computer simulation will be described, with reference to Figures 2 to 5.

The explanation is made by using an amplification apparatus that is not equipped with a fixed predistorter, such as the one shown in Figure 13, as a comparative example with respect to the amplification apparatus of this embodiment that is equipped with the fixed predistorter 11.

A distortion compensation table generally has a table relating to amplitude and a table relating to phase, but to simplify the explanation, here the explanation focuses just on a table relating to amplitude. A table relating to amplitude is the same as with respect to a table relating to phase.

Figure 2 shows an example of a characteristic (a) of the distortion compensation table of the comparative example, and an example of a characteristic (b) of the distortion compensation table of this embodiment stored in memory 3. In the graph of the drawing, the horizontal axis represents power and the vertical axis represents control signal voltage (control voltage).

Figure 3 shows an example of the spectrum (a) of a control voltage from the D/A converter 54 (or the same, with respect to D/A converter 56) of the comparative example, and an example of the spectrum (b) of a control voltage from the D/A converter 4 (or the same, with respect to D/A converter 6), when the sampling frequency fs was set at approximately 60 [MHz]. In the graph of the drawing, the horizontal axis represents frequency [MHz] and the vertical axis represents spectral intensity (level) [dB].

In the drawing, comparative example (a) and this embodiment (b) have the same spectral intensity with respect to direct current (DC) components. A comparison of other frequency components shows that the spectral intensity of this embodiment (b) is approximately 10 [dB] lower than that of the comparative example (a). This is because the characteristic of the distortion compensation table of this embodiment is closer to a straight line than the characteristic of the distortion compensation table of the comparative example. For example, even at 15 [MHz] or above, the comparative example (a) contains components that necessitate distortion compensation, while there is sufficient attenuation in the case of this embodiment (b).

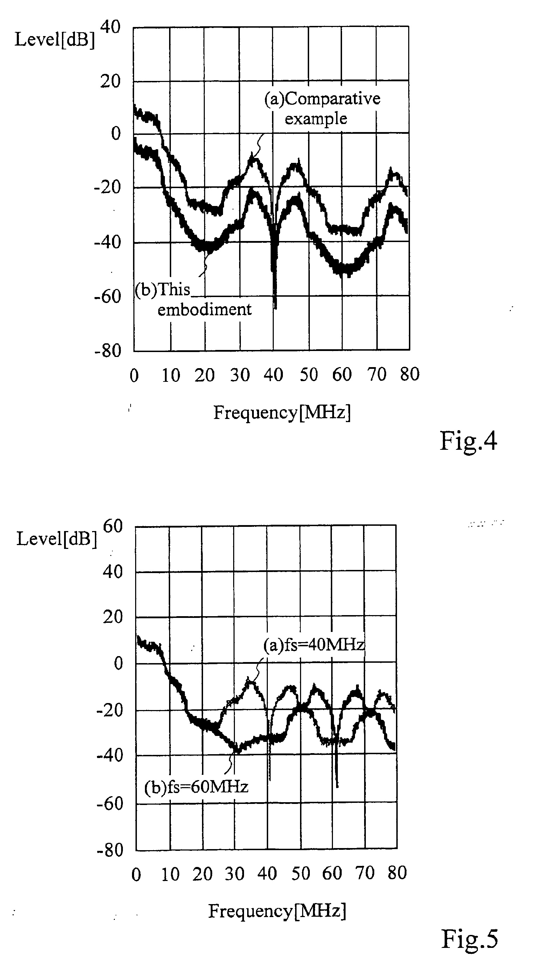

Figure 4 shows an example of the spectrum (a) of a control voltage from the D/A converter 54 (or the same, with respect to D/A converter 56) of the comparative example, and an example of the spectrum (b) of a control voltage from the D/A converter 4 (or the same, with respect to D/A converter 6), when the sampling frequency fs was set at approximately 40 [MHz]. In the graph of the drawing, the horizontal axis represents frequency [MHz] and the vertical axis represents spectral intensity (level) [dB].

When the sampling frequency fs is 40 [MHz], the effect of the image signal output from the D/A converter is stronger compared to when the sampling frequency fs is 60 [MHz].

In the drawing, at approximately 20 [MHz] where there is overlap between the control signal and the image signal, the spectral intensity is attenuated to approximately -40 [dB] in the case of this embodiment (b), but at approximately -25 [dB] in the case of the comparative example (a), is large, and the signal components requiring distortion compensation is affected by the image signal.

With respect to the comparative example, Figure 5 shows an example of the spectrum (a) of a control voltage from the D/A converter 54 (or the same, with respect to D/A converter 56) when the sampling frequency fs was set at approximately 40 [MHz], together with an example of the spectrum (b) of a control voltage from the D/A converter 54 (or the same, with respect to D/A converter 56) when the sampling frequency fs was set at approximately 60 [MHz]. In the graph of the drawing, the horizontal axis represents frequency [MHz] and the vertical axis represents spectral intensity (level) [dB]. At about 20 [MHz], a spectral difference can be confirmed that is due to the difference in sampling frequencies. At an fs of about 40 [MHz], the effect of the image signal, already there at about 20 [MHz], can be seen.

As described in the above, the amplification apparatus of this embodiment is equipped with an adaptive predistorter comprised of the voltage-variable attenuator 9, the voltage-variable phase shifter 10, the D/A converters 4, 6 and so forth, and another predistorter for reducing the wideband signal effect.

Although an adaptive control apparatus, for example, such as said adaptive predistorter can be used as the other predistorter, this embodiment used one in which the distortion information for predistortion compensation is a fixed setting (fixed predistorter 11). In this embodiment, a fixed predistorter 11 for analog applications was used in which digital processing is not performed.

In the amplification apparatus of this embodiment, also, the input/output characteristics of the fixed predistorter 11 were adjusted and set for compensation of distortion generated in an amplifier consisting of the amplification unit 12. Also, a result of using the fixed predistorter 11 to compensate for distortion generated by the amplification unit 12 by the predistortion method is that, compared to the prior art, there is less nonlinearity in the distortion compensation table of the memory 3 in the adaptive predistorter, decreasing the spectral intensity on the high frequency side and low frequency side of the output (control signal) from the D/A converters 4, 6.

Thus, with the amplification apparatus of this embodiment, the spreading of the distortion components to the wideband is reduced, alleviating the wideband signal effect, by using coarse distortion compensation performed by the fixed predistorter 11, which is constituted by an analog device, along with which, accompanying the digital processing, distortion compensation is carried out with good accuracy by the adaptive predistorter adapting to temperature and other environmental changes and aging. Also, by using a fixed predistorter 11 in the amplification apparatus of this embodiment, the load is distributed and the spectral intensity of the control signals in the adaptive predistorter can be reduced, making it possible to lower the sampling rate (sampling frequency) of the digital system, and to lower the clock frequency in the adaptive predistorter and the like.

Therefore, high-speed devices do not necessarily have to be used with the amplification apparatus of this embodiment, so that compared to the prior art, for example, circuit configurations can readily be technologically implemented, and implemented at a low cost. With the amplification apparatus of this embodiment, the convergence speed of the distortion compensation by the adaptive predistorter updating the content of the distortion compensation table can also be increased, compared, for example, to the prior art. With the amplification apparatus of this embodiment, moreover, if required, the frequency pass band of the LPFs 5, 7 through which the control signals pass can, for example, be narrowed. Thus, the amplification apparatus of this embodiment is very effective.

In this embodiment, the fixed predistorter 11 is provided between the voltage-variable phase shifter 10 and the amplification unit 12. However, any location can be used for the fixed predistorter 11, and the same effect obtained, so long as it is in an analog region, for example, at a signal processing location upstream of the amplification unit 12 where distortion compensation by the predistortion method is applied to the input signal to the amplification unit 12.

Specifically, the fixed predistorter 11 can be provided at a location (location "a" in Figure 1) prior to the point at which the input signal is divided on the power detection unit 1 side and the delay unit 8 side, or at a location (location "b" in Figure 1) after the point at which the input signal is divided on the power detection unit 1 side and the delay unit 8 side, upstream of the delay unit 8, or at a location (location "c" in Figure 1) between the delay unit 8 and the voltage-variable attenuator 9, or at a location (location "d" in Figure 1) between the voltage-variable attenuator 9 and the voltage-variable phase shifter 10.

Also, for example, the fixed predistorter 11 can be configured to provide distortion compensation characteristics to either one of the voltage-variable attenuator 9 and the voltage-variable phase shifter 10, or to both.

Also, a voltage-variable amplifier or the like can be used instead of the voltage-variable attenuator 9.

Also, various adaptive predistorters may be used, the adaptive predistorter not being limited to the one of this embodiment.

In the amplification apparatus of this embodiment, moreover, the object of the distortion compensation is the amplifier of the amplification unit 12, and a radio frequency analog signal is used as the signal subject to amplification by the amplification unit 12.

In the amplification apparatus of this embodiment, also, the first distortion generation means is constituted by the functions of the fixed predistorter 11, and the second distortion generation means is constituted by the functions of the adaptive predistorter.

In the amplification apparatus of this embodiment, also, the signal level detection means is constituted by the functions of the power detection unit 1, the signal level distortion generation mode correspondence memory means and the digital control signal output means are constituted by the functions of the memory 3 that stores the distortion compensation table, the control signal D/A conversion means is constituted by the functions of the D/A converters 4, 6, and the amplitude/phase distortion generation means is constituted by the functions of the voltage-variable attenuator 9 and the functions of the voltage-variable phase shifter 10.

In the amplification apparatus of this embodiment, also, the amplified signal portion acquisition means is constituted by the functions of the directional coupler 13, the signal frequency reduction means is constituted by the functions of the oscillator 14 and the functions of the mixer 15, the distortion component extraction means is constituted by the functions of the BPF 16, the distortion component A/D conversion means is constituted by the functions of the A/D converter 17, and the signal level distortion generation mode correspondence content change means is constituted by the functions of the adaptive table control unit 18.

In addition, the adaptive predistorter provided in the amplification apparatus of this embodiment can be constituted using, for example, distortion generation mode control means that controls the distortion generation mode based on the input signal, and distortion generation execution means that generates distortion in accordance with said control, or it can be constituted using distortion generation execution means that, for example, generates distortion in a distortion generation mode that is based on the input signal.

A second embodiment of this invention will now be described.

This embodiment is one in which the distortion compensation apparatus of the present invention is applied to an amplification apparatus equipped with a distortion compensation function (transmission power amplification unit equipped with an adaptive predistorter) such as that shown in Figure 14, to reduce the clock signal frequency (clock frequency) compared, for example, to the prior art, by using a fixed predistorter.

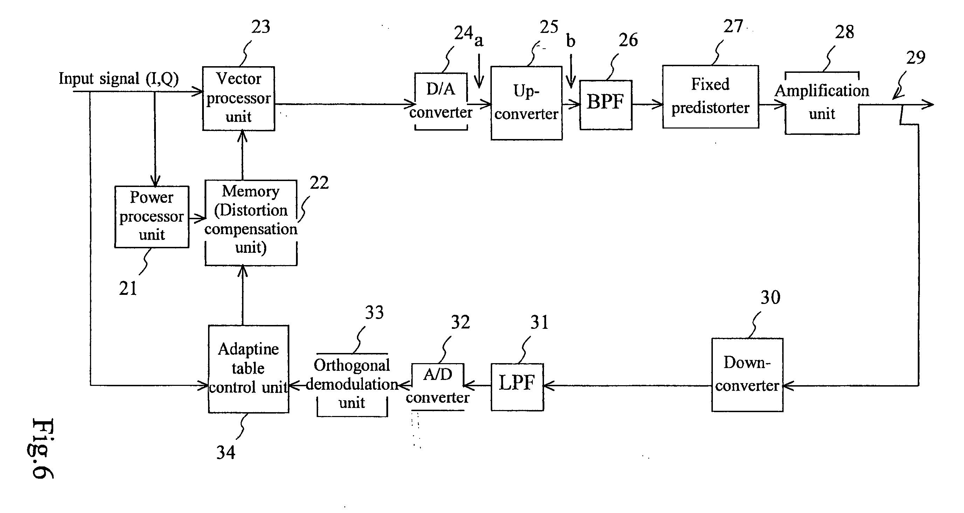

Figure 6 shows an example of the configuration of the amplification apparatus of this embodiment.

The amplification apparatus of this embodiment comprises a power processor unit 21, a memory 22 that stores a distortion compensation table, a vector processor unit 23, a D/A converter 24, an up-converter 25, a bandpass filter (BPF) 26, a fixed predistorter 27, an amplification unit 28, a directional coupler 29, a down-converter 30, a low pass filter (LPF) 31, an A/D converter 32, and an adaptive table control unit 34.

The configuration and operation of the amplification apparatus of this embodiment are the same as the configuration and operation of the amplification apparatus shown in Figure 14, except for the portion pertaining to the lowering of the clock frequency required for the digital system by the use of the fixed predistorter 2 7, for example.

The operation of the amplification apparatus of this embodiment will now be described.

A signal to be input to the amplification apparatus of this embodiment from an upstream processor unit (not shown) is split into three signals, the first split signal is input to the power processor unit 21, the second split signal is input to the vector processor unit 23 and the third split signal is input to the adaptive table control unit 34.

The power processor unit 21 detects the power of the I component and Q component signal to be transmitted, input from an upstream processor unit (not shown), and outputs the detection result to the memory 22.

In the case of the amplification apparatus of this embodiment, an orthogonal modulation method is used to modulate the input signal by the time it is input. However, an example of another configuration can be used in which orthogonal modulation means is provided in the amplification apparatus at a location such as between the vector processor unit 23 and the D/A converter 24, the signal is input without being orthogonally modulated, and the signal is orthogonally modulated by the orthogonal modulation means.

Based on the content of the stored distortion compensation table, the memory 22 uses the digital signal input from the power processor unit 21 as an index to reference the distortion compensation table, and outputs the result to the vector processor unit 23. Specifically, the distortion compensation table stores the association between a digital signal value representing a power detection result, and a control value to the vector processor unit 23. The memory 22 references the distortion compensation table and outputs to the vector processor unit 23 the control value (digital control signal) associated with the value of the digital signal input from the power processor unit 21.

The vector processor unit 23 controls the amplitude and phase of the I component and Q component signal to be transmitted that is input from an upstream processor unit (not shown), using an amplitude change amount and phase change amount that are in accordance with a digital control signal input from the memory 22, and after said control, outputs the signal to the D/A converter 24.

The D/A converter 24 converts the signal input from the vector processor unit 23 from a digital signal to an analog signal, and outputs it to the up-converter 25.

The up-converter 25 converts the frequency of the signal input from the D/A converter 24 to a radio frequency (RF), and outputs the frequency-converted signal to the BPF 26.

The BPF 26 limits the band of the signal input from the up-converter 25, and outputs the band-limited signal to the fixed predistorter 27.

The fixed predistorter 27 is constituted using a nonlinear device, for example, generates distortion with respect to a signal input from the BPF 26, and outputs the distortion-generated signal to the amplification unit 28. Also, the fixed predistorter 27 generates distortion of the signal that corresponds to the level of the input signal.

In this way, in this embodiment, distortion compensation is carried out by the predistortion method by both adaptive predistortion using the vector processor unit 23, and fixed predistortion (nonlinear predistortion) using the fixed predistorter 27.

The amplification unit 28 amplifies the signal input from the fixed predistorter 27 and outputs the amplified signal to a downstream antenna (not shown), for example.

In this embodiment, also, distortion generated in the signal by the amplification unit 28 is reduced by amplitude distortion or phase distortion generated by the vector processor unit 23, or amplitude distortion or phase distortion generated by the fixed predistorter 27.

The directional coupler 29 extracts part of the amplified signal output from the amplification unit 28, and outputs the extracted signal to the down-converter 30.

The down-converter 30 converts the frequency of the amplified signal input from the directional coupler 29 to a lower frequency, and outputs the frequency-converted amplified signal to the LPF 31.

The LPF 31 limits the band of the signal input from the down-converter 30, and outputs the band-limited signal to the A/D converter 32.

The A/D converter 32 converts the signal input from the LPF 31 from an analog signal to a digital signal, and outputs it to the orthogonal demodulation unit 33.

The orthogonal demodulation unit 33 orthogonally demodulates the signal input from the A/D converter 32, and outputs a digital signal corresponding to the orthogonal demodulation result to the adaptive table control unit 34.

The adaptive table control unit 34 digital signal input from the A/D converter 17, the adaptive table control unit 18 updates the content of the distortion compensation table stored in the memory, based on the I component and Q component signal that is to be transmitted, input from an upstream processor unit (not shown), and the orthogonal demodulation result signal (I component and Q component signal) input from the orthogonal demodulation unit 33.

Here, in this embodiment, signal components corresponding to the input signal are extracted by the LPF 31, the adaptive table control unit 34 controls the updating of the content of the distortion compensation table to reduce error between the extracted signal components and the original input signal; the frequency conversion characteristics of the down-converter 30 and the bandpass characteristic of the LPF 31 are set or controlled to properly perform such control.

Next, the principle of the clock frequency reduction using the fixed predistorter 27 in the amplification apparatus of this embodiment will be described, with reference to Figures 9, 10 and 12.

A distortion compensation table generally has a table relating to amplitude and a table relating to phase, but to simplify the explanation, here the configuration is taken to be one in which the distortion compensation table uses a polar coordinate representation that is equivalent to the memory 22, and focuses just on a table relating to amplitude. A table relating to amplitude is the same as with respect to a table relating to phase.

Figure 9 shows an example of the characteristic of the ideal distortion compensation table of an adaptive predistorter using the vector processor unit 23 in a configuration that is not equipped with the fixed predistorter 27. In the graph of the drawing, the horizontal axis represents power and the vertical axis represents the control signal value relating to amplitude (amplitude control value).

Figure 10 shows an example of the characteristics of distortion compensation by the fixed predistorter 27 in a case in which the fixed predistorter 27 is provided, and an example of the characteristic of an ideal distortion compensation table of an adaptive predistorter using the vector processor unit 23. In the graph of the drawing, the horizontal axis represents power and the vertical axis represents the control signal value relating to amplitude (amplitude control value).

The characteristics shown in Figure 10 are a fixed predistortion (fixed PD) characteristic together with an adaptive predistortion (adaptive PD) characteristic; a match with the ideal predistortion (ideal PD) shown in Figure 9 is ideal and desirable.

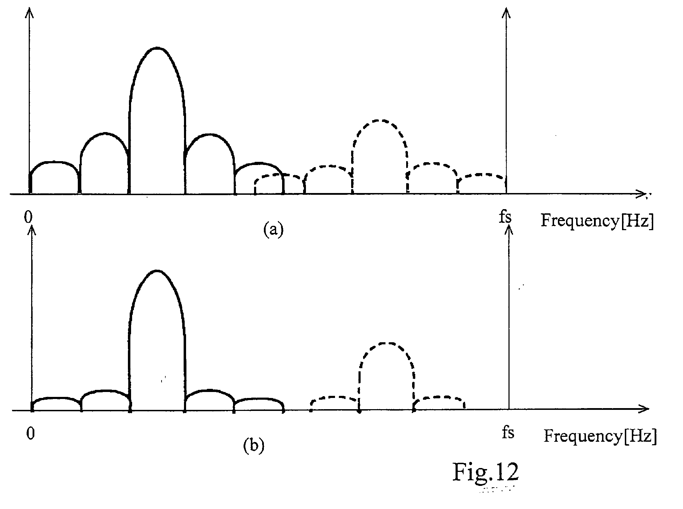

Figure 12 (a) shows, in a case in which the fixed predistorter 27 is not provided, an example of the spectrum of a signal output from the D/A converter 24 when the distortion compensation table of memory 22 has the ideal characteristic shown in Figure 9.

Figure 12 (b) shows, in a case in which the fixed predistorter 27 is provided, an example of the spectrum of a signal output from the D/A converter 24 when the distortion compensation table of memory 22 has the ideal adaptive predistortion (adaptive PD) characteristic shown in Figure 10.

In the graphs shown in Figure 12 (a) and (b), the horizontal axis represents frequency [Hz] and the vertical axis represents spectral intensity.

Also, (a) and (b) of the drawing show the spectrum of a control signal (indicated by a solid line) having a center frequency of 0 [Hz], and an image signal (indicated by a dotted line) having a center frequency of fs [Hz].

As shown in Figure 12 (a) and (b), even at the sampling frequency fs at which the control signal output from the D/A converter 24 and the image signal overlap when there is no fixed predistorter 27, providing the fixed predistorter 27 makes it possible to make the frequency bandwidth of the control signal output from the D/A converter 24 relatively small (narrow), making it possible to avoid overlap between the control signal and the image signal.

Thus, with a configuration that is equipped with the fixed predistorter 27, as in this embodiment, the sampling frequency fs can be made lower compared to a case in which a fixed predistorter is not provided, as shown in Figure 14, for example, which makes it possible to reduce the clock frequency of a digital system such as the D/A converter 24.

Since an analog device is used as the fixed predistorter 27, there is no particular connection with the sampling rate (sampling frequency). In this embodiment, by using this type of fixed predistorter 27, the spectral intensity of the distortion components generated by an adaptive predistorter is attenuated, thereby achieving a lowering of the sampling frequency fs and the clock frequency.

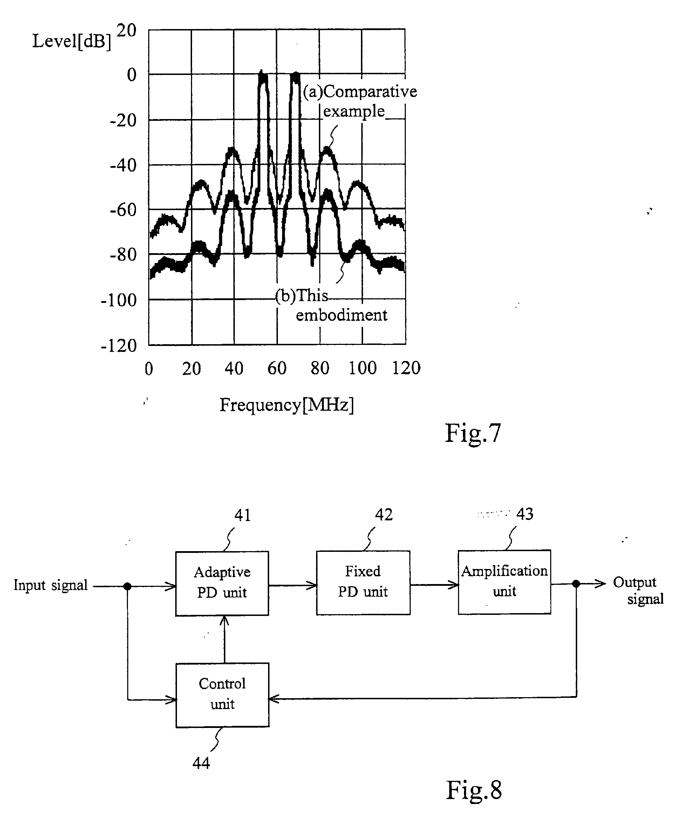

Next, as a concrete example of the effect obtained by the amplification apparatus of this embodiment, results obtained by computer simulation will be described, with reference to Figures 2 and 7.

The explanation is made by using an amplification apparatus that is not equipped with a fixed predistorter, such as the one shown in Figure 14, as a comparative example with respect to the amplification apparatus of this embodiment that is equipped with the fixed predistorter 27.

A distortion compensation table generally comprises a table relating to amplitude and a table relating to phase, but to simplify the explanation, here the configuration is taken to be one in which the distortion compensation table uses a polar coordinate representation that is equivalent to the memory 22, and focuses just on a table relating to amplitude. A table relating to amplitude is the same as with respect to a table relating to phase.

Figure 2 shows an example of a characteristic (a) of the distortion compensation table of the comparative example, and an example of a characteristic (b) of the distortion compensation table of this embodiment stored in memory 22. In the graph of the drawing, the horizontal axis represents power and the vertical axis represents control signal value relating to amplitude (amplitude control value).

Figure 7 shows an example of the spectrum (a) of a signal from the D/A converter 74 according to a comparative example, together with an example of the spectrum (b) of a signal from the D/A converter 24 of this embodiment, in a case in which a two-carrier signal has been modulated by a CDMA system. In the graph of the drawing, the horizontal axis represents frequency [MHz] and the vertical axis represents spectral intensity (level) [dB].

As shown in the drawing, the spectral intensity of the distortion components generated by the adaptive predistorter in the case of this embodiment (b) are attenuated compared to the comparative example (a).

Here, considering the sampling frequency, first, the accuracy of the distortion compensation is determined by the characteristics required of the apparatus, such as adjacent channel leak power (ACP) and the like, from which the requisite accuracy of the output from the D/A converter 24 (for example, power referenced to the carrier [dBc]) is determined.

As one example, when the required accuracy of the distortion compensation is -60 [dBc], in the case of the comparative example (a) a frequency band of about 90 [MHz] is needed, and a clock frequency of twice that, or about 180 [MHz], is required for the D/A converter 74. However, in the case of this embodiment (b), a frequency band of only about 60 [MHz] is required, and a clock frequency of twice that, or about 120 [MHz], is required for the D/A converter 24.

In the case of this embodiment (b), also, the intermediate frequency (IF) can be lowered, and it is also possible to narrow the filter (BPF 26, for example) band.

In the case of this embodiment (b), also, it is possible to reduce the clock frequency of the D/A converter 24 and other digital processing systems, and even if the clock frequency is lowered, a distortion compensation accuracy can be obtained this is about of the same order as that of the comparative example (a).

As described in the above, the amplification apparatus of this embodiment is equipped with an adaptive predistorter comprised of the vector processor unit 23 and so forth, and another predistorter for reducing the wideband signal effect.

Although an adaptive control apparatus, for example, such as said adaptive predistorter can be used as the other predistorter, this embodiment used one in which the distortion information for predistortion compensation is a fixed setting (fixed predistorter 27). In this embodiment, a fixed predistorter 27 for analog applications was used in which digital processing is not performed.

In the amplification apparatus of this embodiment, also, the input/output characteristics of the fixed predistorter 27 were adjusted and set for compensation of distortion generated in an amplifier consisting of the amplification unit 12. Also, a result of using the fixed predistorter 27 to compensate for distortion generated by the amplification unit 12 by the predistortion method is that, compared to the prior art, there is less nonlinearity in the distortion compensation table of the memory 22 in the adaptive predistorter, decreasing the spectral intensity on the high frequency side and low frequency side of the output (adaptively predistorted signal) from the D/A converter 24.

Thus, with the amplification apparatus of this embodiment, the spreading of the distortion components to the wideband is reduced, alleviating the effect on the wideband signal, by using coarse distortion compensation performed by the fixed predistorter 27, which is constituted by an analog device, along with which, accompanying the digital processing, distortion compensation is carried out with good accuracy by the adaptive predistorter adapting to temperature and other environmental changes and aging. Also, by using a fixed predistorter 27 in the amplification apparatus of this embodiment, the load is distributed and the spectral intensity of the control signals in the adaptive predistorter can be reduced, making it possible to lower the sampling rate (sampling frequency) of the digital system, and to lower the clock frequency in the adaptive predistorter and the like.

Therefore, high-speed devices do not necessarily have to be used with the amplification apparatus of this embodiment, so that compared to the prior art, for example, circuit configurations can readily be technologically implemented, and implemented at a low cost. With the amplification apparatus of this embodiment, the convergence speed of the distortion compensation by the adaptive predistorter updating the content of the distortion compensation table can also be increased, compared, for example, to the prior art. With the amplification apparatus of this embodiment, moreover, if required, the frequency pass band of the BPF 26 through which the control signals pass can, for example, be narrowed. Thus, the amplification apparatus of this embodiment is very effective.

In this embodiment, the fixed predistorter 27 is provided between the BPF 26 and the amplification unit 28. However, any location can be used for the fixed predistorter 27, and the same effect obtained, so long as it is in an analog region, for example, at a signal processing location upstream of the amplification unit 28 where distortion compensation by the predistortion method is applied to the input signal to the amplification unit 28.

Specifically, the fixed predistorter 28 can be provided at a location (location "a" in Figure 6) between the D/A converter 24 and the up-converter 25, or at a location (location "b" in Figure 1) between the up-converter 25 and the BPF 26.

Also, various adaptive predistorters may be used, the adaptive predistorter not being limited to the one of this embodiment.

In the amplification apparatus of this embodiment, moreover, the object of the distortion compensation is the amplifier of the amplification unit 28, and a digital signal comprised of baseband (BB) or intermediate frequency (IF) I components and Q components is used as the signal subject to amplification by the amplification unit 28.

In the amplification apparatus of this embodiment, also, the first distortion generation means is constituted by the functions of the fixed predistorter 27, and the second distortion generation means is constituted by the functions of the adaptive predistorter.

In the amplification apparatus of this embodiment, also, the signal level detection means is constituted by the functions of the power processor unit 21, the signal level distortion generation mode correspondence memory means and the digital control signal output means are constituted by the functions of the memory 22 that stores the distortion compensation table, the amplitude/phase distortion generation means is constituted by the functions of the vector processor unit 23, the signal D/A conversion means is constituted by the functions of the D/A converter 24, and the signal frequency conversion means is constituted by the functions of the up-converter 25.

In the amplification apparatus of this embodiment, also, the amplified signal portion acquisition means is constituted by the functions of the directional coupler 29, the signal frequency reduction means is constituted by the functions of the oscillator 14 and the functions of the down-converter 30, the signal filtering means is constituted by the functions of the LPF 31, the filtered signal A/D conversion means is constituted by the functions of the A/D converter 32, the signal demodulation means is constituted by the functions of the orthogonal demodulation unit 33, and the signal level distortion generation mode correspondence content change means is constituted by the functions of the adaptive table control unit 34.

In addition, the adaptive predistorter provided in the amplification apparatus of this embodiment can be constituted using, for example, distortion generation mode control means that controls the distortion generation mode based on the input signal, and distortion generation execution means that generates distortion in accordance with said control, or it can be constituted using distortion generation execution means that, for example, generates distortion in a distortion generation mode that is based on the input signal.

A third embodiment of this invention will now be described.

This embodiment shows an example of a simplified configuration as an example of an amplification apparatus in which the distortion compensation apparatus of this invention is applied. In the amplification apparatus of this embodiment, various configurations can be implemented with respect to the simplified configuration portions.

Figure 8 shows an example of the configuration of the amplification apparatus of this embodiment.

The amplification apparatus of this embodiment comprises an adaptive predistortion unit (adaptive PD unit) 41 that performs adaptive predistortion processing, a fixed predistortion unit (fixed PD unit) 42 that performs fixed predistortion processing, an amplification unit 43 that is the object of the distortion compensation, and a control unit 44 that controls the adaptive PD unit 41.

The operation of the amplification apparatus of this embodiment will now be described.

A signal to be input to the amplification apparatus of this embodiment from an upstream processor unit (not shown) is split into two signals, the first split signal is input to the adaptive PD unit 41 and the second split signal is input to the control unit 44.

The adaptive PD unit 41 uses the adaptive predistortion method to generate distortion with respect to a signal input from an upstream processor unit (not shown), and outputs the distortion-generated signal to the fixed PD unit 42.

The fixed PD unit 42 uses the adaptive predistortion method to generate distortion with respect to the signal input from the adaptive PD unit 41, and outputs the distortion-generated signal to the amplification unit 43.

The amplification unit 43 amplifies the signal input from the fixed PD unit 42, and outputs the amplified signal to a downstream antenna (not shown), for example.

Part of the amplified signal output from the amplification unit 43 is extracted and input to the control unit 44.

The control unit 44 performs control relating to the adaptive predistortion processing by the adaptive PD unit 41, based on one or both of the signal input from an upstream processor unit (not shown), and the amplified signal fed back from the amplification unit 43.

As described in the above, by providing the amplification apparatus of this embodiment with the adaptive PD unit 41 and another PD unit (fixed PD unit 42, in this embodiment), the clock frequency required, for example, for the adaptive PD unit 41 and the like, can be reduced to improve distortion compensation efficiency.

In the amplification apparatus of this embodiment, moreover, the object of the distortion compensation is the amplifier of the amplification unit 43, the first distortion generation means is constituted by the functions of the fixed PD unit 42, and the second distortion generation means is constituted by the functions of the adaptive PD unit 41.

In the adaptive predistorter provided in the amplification apparatus of this embodiment, the distortion generation mode control means that controls the distortion generation mode based on the input signal, for example, can be constituted by the functions of the control unit 44, and the distortion generation execution means that generates distortion in accordance with said control can be constituted by the adaptive PD unit 41.

In this specification, the apparatus that applies analog nonlinearity with respect to input to the amplifier has been described using the expression "fixed predistorter." However, cases in which other expressions are used such as "linearizer," for example, provided the apparatus is the same, are also encompassed by the present invention.

The configuration of the distortion compensation apparatus, amplification apparatus, communication apparatus and so forth of this invention are not limited to that set out in the foregoing, and various other configurations can also be used. Also, this invention may be provided as a program for the methods or systems of executing the processing of this invention, for example, or for realizing such methods and systems.

In addition, the field of application of the invention is not necessarily limited to that described in the foregoing, and application of the invention to various other fields is also possible.

Moreover, the various types of processing performed in the distortion compensation apparatus, amplification apparatus, communication apparatus and so forth of this invention may be constituted by being implemented in hardware resources equipped with a processor and memory and the like, for example, being controlled by means of a processor executing a control program stored in ROM (Read Only Memory). Further, the various functional means for executing this processing may also be constituted as independent hardware circuits.

In addition, the present invention may also be understood as one wherein the above control program (itself) is stored on a Floppyp disc, . CD (Compact Disc)-ROM or other computer-readable recording media, so that the processing according to the present invention can be implemented by said control program being input from the recording media into a computer and executed by a processor.

### INDUSTRIAL APPLICABILITY

As described in the foregoing, in accordance with the distortion compensation apparatus of this invention, a first distortion generation unit constituted by an analog device, for example, that generates distortion with respect to a signal subject to amplification by an amplifier, to reduce distortion generated by the amplifier, and in addition, upstream or downstream of the first distortion generation unit, a second distortion generation unit including, for example, a digital device that generates distortion with respect to a distortion of a signal subject to amplification by the amplifier generated by the amplifier, to reduce components not reduced by the distortion from the first distortion generation unit, thereby compensating for distortion generated by the amplifier amplifying the signal, thus serving to improve distortion compensation efficiency. Specifically, compared to the prior art, the sampling frequency and clock frequency required for the digital devices can be lowered, making it easier to achieve and implement at a lower cost.

## Claims

1. A distortion compensation apparatus that compensates for distortion generated in a signal amplified by an amplifier, wherein:
the distortion compensation apparatus is **characterized by** comprising:
first distortion generation means that generates distortion with respect to a signal that is subject to amplification by an amplifier, to reduce distortion generated by the amplifier; and
second distortion generation means that, based on a signal that is subject to amplification by an amplifier, generates distortion with respect to said signal to decrease components other than components decreased by distortion generated by the first distortion generation means in respect of distortion generated by the amplifier.

2. A distortion compensation apparatus according to claim 1, wherein:
the distortion compensation apparatus is **characterized by** comprising:
first distortion generation means constituted using an analog device and having a function of generating distortion in a mode that is fixedly set with respect to a signal subject to amplification by an amplifier;
second distortion generation means that includes a digital device that performs operations based on a clock signal;
the second distortion generation means being constituted by a distortion generation mode control means that controls the distortion generation mode based on the signal subject to amplification by the amplifier, and a distortion generation execution means that generates distortion with respect to the signal subject to amplification by the amplifier in the distortion generation mode controlled by the distortion generation mode control means.

3. A distortion compensation apparatus according to claim 1 or 2, wherein:
the distortion compensation apparatus is **characterized by** comprising:
second distortion generation means constituted using signal level detection means that detects the level of a signal subject to amplification by the amplifier; signal level distortion generation mode correspondence memory means that stores the correspondence between signal level and distortion generation mode; distortion generation control execution means that, based on the stored content of the signal level distortion generation mode correspondence memory means, generates distortion in respect of the signal subject to amplification by the amplifier, using a distortion generation mode corresponding to the signal level detected by the signal level detection means; and signal level distortion generation mode correspondence content change means that modifies the content of the correspondence between the signal level and the distortion generation mode stored by the signal level distortion generation mode correspondence memory means.

4. A distortion compensation apparatus according to any of claims 1 to 3, wherein:
the distortion compensation apparatus is **characterized by** comprising:
a radio frequency analog signal input to the distortion compensation apparatus as a signal subject to amplification by the amplifier;
second distortion generation means constituted using signal level detection means that detects the level of an analog signal subject to amplification by the amplifier; digital control signal output means that has a signal level distortion generation mode correspondence memory means that stores the correspondence between signal level and distortion generation mode and outputs a digital control signal to realize the distortion generation mode corresponding to the signal level detected by the signal level detection means; control signal D/A conversion means that converts the digital control signal output by the digital control signal output means to an analog control signal; and amplitude/phase distortion generation means that, based on the analog control signal obtained by the control signal D/A conversion means, generates one of amplitude and phase, or amplitude and phase, distortion in respect of the analog signal subject to amplification by the amplifier;
first distortion generation means that generates distortion with respect to the analog signal in which distortion was generated by the amplitude/phase distortion generation means constituted by the second distortion generation means, and outputs the analog signal in which said distortion was generated to the amplifier.

5. A distortion compensation apparatus according to any of claims 1 to 3, wherein:
the distortion compensation apparatus is **characterized by** comprising:
a digital signal comprised of I components and Q components input to the distortion compensation apparatus as a signal subject to amplification by the amplifier;
second distortion generation means constituted using signal level detection means that detects the level of a digital signal subject to amplification by the amplifier; digital control signal output means that has a signal level distortion generation mode correspondence memory means that stores the correspondence between the signal level and the distortion generation mode and outputs a digital control signal to realize the distortion generation mode corresponding to the signal level detected by the signal level detection means; and amplitude/phase distortion generation means that generates one of amplitude and phase, or amplitude and phase, distortion in respect of the digital signal subject to amplification by the amplifier, based on the digital control signal output by the digital control signal output means;
said distortion compensation apparatus comprising signal D/A conversion means that converts the digital signal in which distortion was generated by the amplitude/phase distortion generation means constituted by the second distortion generation means to an analog signal; and signal frequency conversion means that converts the frequency of the analog signal obtained by the signal D/A conversion means to a radio frequency;
first distortion generation means that generates distortion with respect to the radio frequency analog signal obtained using the signal frequency conversion means, and outputs the analog signal in which this distortion has been generated to the amplifier.
